# EUROPEAN PATENT APPLICATION

(11) **EP 2 509 085 A2**
(43) Date of publication of application: **10.10.2012**
(21) Application number: 11188507.5
(22) Date of filing: 09.11.2011
(51) Int. Cl.: H01G 9/20

(54) **Electrolyte for dye-sensitized solar cell and dye-sensitized solar cell including the same**

(30) Priority: 06.04.2011 KR 20110031799
(71) Applicant: Samsung SDI Co., Ltd., Yongin-si, Gyeonggi-do (KR)
(72) Inventor: Kang, Moon-Sung, Gyeonggi-do (KR); Lee, Ji-Won, Gyeonggi-do (KR); Cha, Si-Young, Gyeonggi-do (KR)
(74) Representative: Sampson, Eimear

(57) **Abstract**

An electrolyte for a dye-sensitized solar cell, the electrolyte including an organic solvent; a redox derivative; and an additive including a linear carbon chain, wherein the additive has an ionic or non-ionic neutral functional group located at one or more ends of the linear carbon chain.

## Description

The present invention relates to an electrolyte for dye-sensitized solar cells and dye-sensitized solar cells including the same.

Dye-sensitized solar cells are photo-electrochemical solar cells that include photosensitive dye molecules capable of generating electron-hole pairs by absorbing visible light and an oxide semiconductor electrode that transfers generated electrons and comprises titanium oxide. These dye-sensitized solar cells include a photocathode including a semiconductor oxide nanoparticle layer onto which dye molecules are adsorbed, a counter electrode including a platinum catalyst, and an electrolyte including a redox ion couple.

In particular, the electrolyte of the dye-sensitized solar cell greatly contributes to durability and efficiency such as in terms of fill factor (FF) of solar cells.

In these dye-sensitized solar cells, liquid electrolytes including a low-density volatile organic solvent are commonly used. The liquid electrolytes have high ionic conductivity, thereby exhibiting high efficiency. However, the liquid electrolyte is highly volatile and liable to leak, thereby deteriorating the durability of solar cells. Therefore, to prevent the electrolyte from being volatile or leaking, a high-density solvent having a high boiling point can be used.

However, liquid electrolytes including the high-density solvent have low ionic conductivity, and thus the internal resistance of solar cells greatly increases and the efficiency, such as in terms of the FF of solar cells, is much lower than that of solar cells including electrolytes including the low-density volatile organic solvent.

According to a first aspect of the present invention, an electrolyte for a dye-sensitized solar cell includes an organic solvent; a redox derivative; and an additive including a linear carbon chain, wherein the additive has an ionic or non-ionic neutral functional group located at one or more ends of the linear carbon chain.

According to a second aspect of the present invention, a dye-sensitized solar cell includes a first electrode on which a porous film with a dye adsorbed onto a surface thereof is formed; a second electrode facing the surface of the first electrode on which the porous film is formed; and the electrolyte according to the invention in its first aspect interposed between the first electrode and the second electrode.

According to a third aspect of the present invention there is provided the use of an electrolyte according to the invention in its first aspect in a dye-sensitized solar cell.

An electrolyte for a dye-sensitized solar cell according to the present invention may have excellent ionic conductivity.

A dye-sensitized solar cell including the electrolyte according to the present invention may exhibit enhanced durability and efficiency such as an improved fill factor (FF).

A more complete appreciation of the present invention, and many of the attendant advantages thereof, will be readily apparent as the same becomes better understood by reference to the following detailed description when considered in conjunction with the accompanying drawings, wherein:
FIG. 1 is a schematic diagram illustrating an operating principle of a dye-sensitized solar cell;
FIG. 2 is a schematic diagram illustrating action of an electrolyte for a dye-sensitized solar cell, according to an embodiment of the present invention;
FIG. 3 is a schematic diagram illustrating action of an electrolyte in a dye-sensitized solar cell; and
FIG. 4 is a cross-sectional view illustrating a structure of a dye-sensitized solar cell according to an embodiment of the present invention.

Reference will now be made in detail to embodiments, examples of which are illustrated in the accompanying drawings, wherein like reference numerals refer to like elements throughout.

The present invention provides an electrolyte for a dye-sensitized solar cell, the electrolyte including an organic solvent, a redox derivative, and an additive including a linear carbon chain, wherein the additive may include an ionic or non-ionic neutral functional group located at one or more ends of the linear carbon chain.

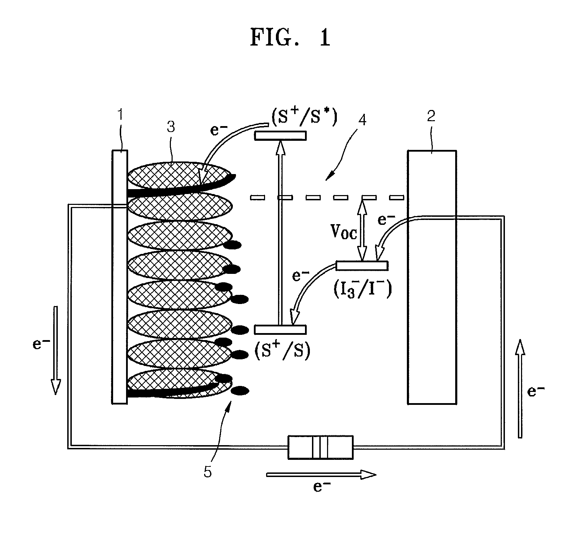

FIG. 1 is a schematic diagram illustrating an operating principle of a general dye-sensitized solar cell. First, when sunlight is absorbed into a dye 5, the dye 5 is subject to electron transfer from a ground state to an excited state, thereby generating electron-hole couples. The excited electrons are injected into a conduction band in a grain boundary of a porous film 3, and the injected electrons are transferred to a first electrode 1 and are then transferred to a second electrode 2 through an external circuit. Meanwhile, the dye 5 oxidized as a result of the electron transfer is reduced by an iodide ion (I⁻) of redox couples in an electrolyte 4, an oxidized trivalent iodide ion (I₃⁻) performs a reduction reaction with the electron, which reaches an interface of the second electrode 2, for charge neutrality. For example, the dye-sensitized solar cell operates on electrochemical principles, utilizing a grain boundary reaction, unlike a general p-n junction silicon (Si) solar cell. The electrolyte of the dye-sensitized solar cell receives the electrons from a counter electrode through a redox reaction of the iodide ions (I-/I₃), and transfers the electrons to the dye.

The durability and efficiency such as fill factor (FF) of a dye-sensitized solar cell may depend on the physical or chemical properties of the electrolyte for a dye-sensitized solar cell.

For example, a low-density volatile organic solvent as an electrolytic solvent easily leaks or becomes volatile, thereby deteriorating the durability of the dye-sensitized solar cell. On the other hand, a high-density organic solvent having a high boiling point has low ionic conductivity, and thus the internal resistance of the dye-sensitized solar cell greatly increases, and a dye-sensitized solar cell including the high-density organic solvent may exhibit lower efficiency than in a dye-sensitized solar cell including the low-density volatile organic solvent.

Examples of the electrolyte for a dye-sensitized solar cell may include molten salts such as pyrrolidinium iodide salt, pyridinium iodide salt, triazolium iodide salt, tetrabutyl ammonium iodide salt, and imidazolium iodide salt. In some embodiments, the electrolyte may be imidazolium iodide salt. When the imidazolium iodide salt is used, the precipitation thereof due to a reduction in solubility at a low temperature does not occur. In addition, it has high ionic conductivity, and thus a dye-sensitized solar cell including the electrolyte may exhibit excellent characteristics. However, the viscosity of the imidazolium iodide salt is from about 300 to 900 times greater than that of a solvent, and thus the viscosity of the electrolyte may greatly depend on the viscosity of the imidazolium iodide salt. In addition, such a high-density electrolyte may have low ionic conductivity.

The electrolyte for a dye-sensitized solar cell according to the invention includes an additive including a linear carbon chain. The additive including a linear carbon chain included in the electrolyte for a dye-sensitized solar cell may reduce the viscosity of the electrolyte including at least one of a high-density organic solvent and imidazolium iodide salt, and enhance the ionic conductivity thereof. The additive includes a linear carbon chain which may comprise from 3 to 20 carbon atoms.

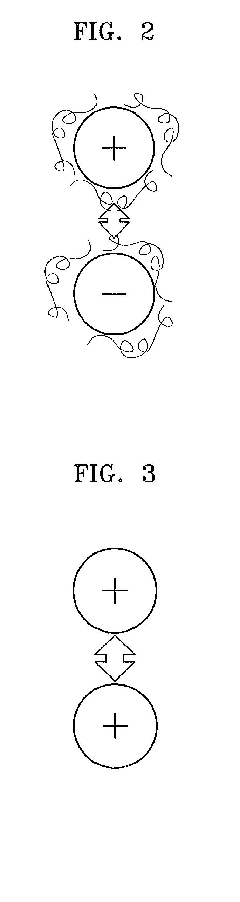

FIG. 2 is a schematic diagram illustrating action of an electrolyte for a dye-sensitized solar cell, according to an embodiment of the present invention. FIG. 3 is a schematic diagram illustrating action of an electrolyte for a general dye-sensitized solar cell.

Referring to FIG. 2, the linear carbon chains of the additive including a linear carbon chain respectively surround an anion (for example, an iodide ion) and a cation (for example, a counter ion of the iodide ion) of a solute or molten salt included in the electrolyte for a dye-sensitized solar cell, thereby blocking the interaction between the anion and the cation. Therefore, the additive including a linear carbon chain included in the electrolyte may reduce the viscosity of the electrolyte and may also accelerate the diffusion of the cation and anion in the electrolyte.

Meanwhile, referring to FIG. 3, the electrolyte does not include the additive including a linear carbon chain, and thus a strong attractive force between an anion (for example, an iodide ion) and a cation (for example, a counter ion of the iodide ion) of a solute or molten salt included in the electrolyte is maintained. Therefore, the viscosity of the electrolyte is high, and the diffusion of the cation and anion may also be reduced by fluid resistance.

The additive including a linear carbon chain may include, in the linear carbon chain, at least one of a hetero atom, an arylene group, and a heteroarylene group.

For example, the hetero atom may be a sulfur (S) atom, a nitrogen (N) atom, or an oxygen (O) atom, and an additive including the O atom in its linear carbon chain may have an ether bond. The additive including the hetero atom in its linear carbon chain includes non-covalent electron pairs, and thus ions may be easily transferred and thus the solubility of the additive in the electrolyte may be high. In addition, the additive may include the arylene group and the heteroarylene group including S, N, or O in the linear carbon chain thereof.

The additive including a linear carbon chain includes an ionic or non-ionic neutral functional group located at one or more ends of the linear carbon chain. For example, the neutral functional group may include a polar functional group.

When an acidic functional group is at the end of the linear carbon chain of the additive, the acidic functional group positively shifts the Fermi level of TiO₂ adsorbed onto the surface of dye molecules, thereby reducing an open circuit voltage. On the other hand, when a basic functional group is at the end of the linear carbon chain of the additive, the pH value of the electrolyte is increased by the basic functional group and the dye is ionized, and thus the ionized dye is dissolved in the electrolyte.

However, since the additive including a linear carbon chain includes the ionic or non-ionic neutral functional group located at one or more ends of the linear carbon chain, the stability of the dye is obtained, voltage may be increased, and the dye-sensitized solar cell may exhibit high efficiency.

For example, the additive including a linear carbon chain may be at least one ionic or non-ionic neutral functional group selected from the group consisting of -F, -Cl, -Br, -I, -NO₃, -CN, -OH, -SH, -CHO, -SbF₆⁻, -PF₆⁻, -AsF₆⁻, -(CF₃CO₂)⁻, -(C₂F₆CO₂)⁻, -(CF₃CF₂CF₂CO₂)⁻, -ClO₄⁻, -(p-CH₃C₆H₄SO₃)⁻, -(SO₃CF₃)⁻, -SO₄⁻, and -HPO₃⁻. However, the additive including a linear carbon chain is not limited to these examples, and may be any neutral functional group that is commonly used in the art.

For example, the additive including a linear carbon chain may be 1,6-dibromohexane, sodium dodecyl sulfate (SDS), polyoxyethylene-p-tertoctylphenylether, or mixtures thereof. However, the additive including a linear carbon chain is not limited to these examples, and may be any compound or mixture used in the art, which includes an ionic or non-ionic neutral functional group located at one or more ends of the linear carbon chain.

The amount of the additive including a linear carbon chain may be in the range of about 0.15 to about 20 parts by weight, for example, in the range of about 1 to about 5 parts by weight based on 100 parts by weight of the organic solvent. When the additive is within this range, the viscosity of the electrolyte is appropriately maintained, and the diffusion of a cation and anion in the electrolyte is accelerated to increase the ionic conductivity of the electrolyte.

The electrolyte for a dye-sensitized solar cell may further include a nanoparticle filler. A nanoparticle filler is a compound or composition which is in the form of nanoparticles (i.e. having at least one dimension less than 100 nm), and which may increase the ionic conductivity of the electrolyte, and solidify or semi-solidify the electrolyte, thereby preventing the electrolyte from leaking from the dye-sensitized solar cell. The nanoparticle filler may be added to the electrolyte together with the additive including a linear carbon chain.

For example, the nanoparticle filler may be a nano-inorganic oxide. The nanoparticle filler may be, for example, at least one compound selected from the group consisting of TiO₂, SiO₂, SnO₂, WO₃, ZnO, ITO, BaTiO₃, Nb₂O₄, In₂O₃, ZrO₂, Ta₂O₅, La₂O₃, SrTiO₃, Y₂O₃, Ho₂O₃, Bi₂O₃, CeO₂, and Al₂O₃. In particular, the nanoparticle filler may be TiO₂, and, more particularly, may be anatase-type TiO₂. The anatase-type TiO₂ may be in the form of a commercialized powder, sol, or slurry, or in the form of a particle produced by a known method of hydrolyzing titanium oxide alkoxide. The nano-inorganic oxide is not dissolved in the organic solvent, and thus is capable of solidifying or semi-solidifying the electrolyte. Therefore, the leakage of the electrolyte from the dye-sensitized solar cell may be prevented.

For example, the nanoparticle filler may be carbon black or carbon nanotube. The carbon nanotube may be single-walled carbon nanotube or multi-walled carbon nanotube. However, the nanoparticle filler is not particularly limited to these examples and may be any nanoparticle filler that is commonly used in the art.

The nanoparticle filler may have an average particle diameter in the range of about 5 to about 400 nm, for example, in the range of about 10 to about 100 nm, and, for example, in the range of about 10 to 50 nm. When the average particle diameter of the nanoparticle filler is within this range, ions are adsorbed and aligned on the surface of particles with a wide specific surface area, whereby the ionic conductivity of the electrolyte may be increased.

The amount of the nanoparticle filler may be in the range of about 0.2 to about 40 parts by weight, for example, in the range of about 2 to about 20 parts by weight based on 100 parts by weight of the organic solvent. When the amount of the nanoparticle filler is within this range, the leakage of the electrolyte may be reduced even though the electrolyte is exposed outside the dye-sensitized solar cell during the manufacturing process or when the solar cell is broken, and the ionic conductivity of the electrolyte may be maintained constant even though the organic solvent is partly leaked.

The organic solvent may have a boiling point of 140°C or higher. For example, the boiling point of the organic solvent may be in the range of about 140°C to about 250°C.

For example, the organic solvent may be, but is not limited to, at least one selected from the group consisting of 3-methoxy propionitrile (MPN), N-methyl-2-pyrrolidone (NMP), ethylene carbonate (EC), propylene carbonate (PC), gamma-butyrolactone (GBL), valeronitrile, dimethylsulfoxide, dimethylformamide, diethylformamide, and dimethylacetamide. The organic solvent has a high density and boiling point, and thus the volatilization and leakage of the electrolyte may be prevented.

A redox derivative is a material configured to provide a redox couple. For example, the redox derivative may produce an I-/I₃⁻ redox couple. For example, the redox couple may exist in the organic solvent at a concentration in the range of about 0.1 to about 1.5 M. The I⁻ and I₃⁻ ions may be produced from an iodized salt, and coexist and reversibly react with each other.

For example, the iodized salt may be at least one of lithium iodide, sodium iodide, potassium iodide, magnesium iodide, copper iodide, silicon iodide, manganese iodide, barium iodide, molybdenum iodide, calcium iodide, iron iodide, caesium iodide, zinc iodide, mercury iodide, ammonium iodide, methyl iodide, methylene iodide, ethyl iodide, ethylene iodide, isopropyl iodide, isobutyl iodide, benzyl iodide, benzoyl iodide, allyl iodide, imidazolium iodide, and 1-propyl-3-methylimidazolium iodide.

The amount of the iodized salt may be in the range of about 150 to about 3,000 parts by weight based on 100 parts by weight of iodine (I₂). When the amount of the iodized salt is within this range, a redox reaction may proceed smoothly, and an electron flow is maintained, thereby increasing a current value.

The present invention also provides a dye-sensitized solar cell including: a first electrode on which a porous film with a dye adsorbed on a surface thereof is formed; a second electrode facing the surface of the first electrode on which the porous film is formed; and the above-described electrolyte interposed between the first electrode and the second electrode.

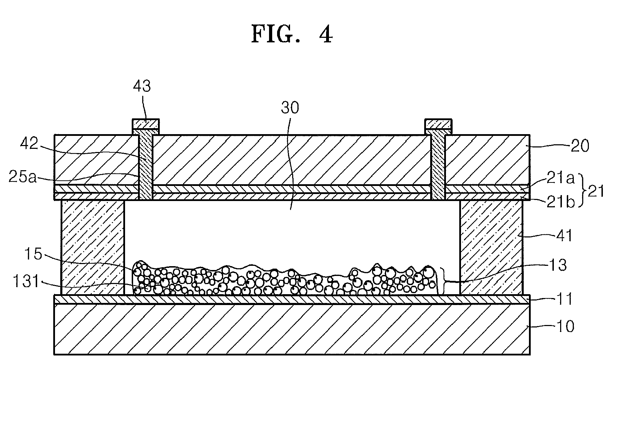

FIG. 4 is a cross-sectional view illustrating the structure of a dye-sensitized solar cell according to an embodiment of the present invention.

Referring to FIG. 4, the dye-sensitized solar cell includes a first substrate 10 on which a first electrode 11, a porous film 13, and a dye 15 are disposed, a second substrate 20 on which a second electrode 21 is disposed, and an electrolyte 30 interposed between the first electrode 11 and the second electrode 21, wherein the first substrate 10 and the second substrate 20 face each other. A separate case (not shown) may be disposed on an external side of the first substrate 10 and the second substrate 20. The elements of the dye-sensitized solar cell will now be described in more detail.

The first substrate 10, which supports the first electrode 11, is transparent to allow external light to be incident onto the first substrate 10. The first substrate 10 may comprise glass or plastic. Examples of the plastic include polyethylene terephthalate (PET), polyethylene naphthalate (PEN), polycarbonate (PC), polypropylene (PP), polyimide (PI), and triacetyl cellulose (TAC).

The first electrode 11, which is disposed on the first substrate 10, may comprise a transparent material such as an indium tin oxide, an indium oxide, a tin oxide, a zinc oxide, a sulfur oxide, a fluorine oxide, mixtures thereof, ZnO-Ga₂O₃, or ZnO-Al₂O₃. The first electrode 11 may include a single or multiple layers of the transparent material.

The porous film 13 is formed on the first electrode 11. The porous film 13 includes metal oxide particles 131 having a very minute and uniform average particle diameter, formed using a self-assembly method. The porous film 13 may also have nanoporous properties, due to having a fine and uniform pore size. The average particle diameter of pores of the porous film 13 may be in the range of about 7.5 nm to about 15 nm. Since the porous film 13 has an appropriate average size of pores, the movement of the electrolyte 30 is enhanced, and necking properties of the metal oxide particles 131 may be enhanced.

The thickness of the porous film 13 may be in the range of about 10 nm to about 3,000 nm, for example, in the range of about 10 nm to about 1,000 nm. However, the thickness of the porous film 13 is not limited to this range.

The metal oxide particles 131 may comprise titanium oxide, zinc oxide, tin oxide, strontium oxide, indium oxide, iridium oxide, lanthan oxide, vanadium oxide, molybdenum oxide, tungsten oxide, niobium oxide, magnesium oxide, aluminium oxide, yttrium oxide, scandium oxide, samarium oxide, gallium oxide, or strontium titanium oxide. In this regard, the metal oxide particles 131 may comprise TiO₂, SnO₂, WO₃, ZnO, or complexes thereof.

The dye 15, which absorbs external light to generate excited electrons, is adsorbed on a surface of the porous film 13. The dye 15 may be a ruthenium-based or organic photosensitizer. For example, the ruthenium-based photosensitizer may be, but is not limited to, an N719 dye such as [cis-bis(isothiocyanato)bis(2,2'-bipyridyl-4,4'-dicarboxylato)-ruthenium(II)-bis tetrabutylammonium], or an N3 dye such as [cis-bis(isothiocyanato)bis(2,2'-bipyridyl-4,4'-dicarboxylato)-ruthenium(II)]. Examples of the organic photosensitizer may include, but are not limited to, 2-Cyano-3-[5"'-(9-Ethyl-9H-carbazol-3-yl)-3',3",3"',4-tetra-n-hexyl-[2,2',5',2",5",2"']-quaterthiophenyl-5-yl]acrylic acid (MK-2), 2-Cyano-3-{5'-[1-cyano-2-(1,1,6,6-tetramethyl-10-oxo-2,3,5,6-tetrahydro-1H,4H,10H-11-oxa-3a-azabenzo[de]anthracen-9-yl)-vinyl]-[2,2']bithiophenyl-5-yl} -acrylic acid (NKX-2883), and 3-{5-[N,N-bis(9,9-dimethylfluorene-2-yl)phenyl]-2,2-bisthiophene-5-yl}-2-cyano-acrylic acid (JK-2).

The second substrate 20 disposed facing the first substrate 10 supports the second electrode 21 and may be transparent. In this regard, the second substrate 20, like the first substrate 10, may comprise glass or plastic.

The second electrode 21, which is a counter electrode, faces the first electrode 11, and may include a transparent electrode 21a and a catalyst electrode 21b.

The transparent electrode 21a may comprise a transparent material, such as indium tin oxide, fluoro tin oxide, antimony tin oxide, zinc oxide, tin oxide, ZnO-Ga₂O₃, or ZnO-Al₂O₃. The transparent electrode 21a may include a single or multiple layers of the transparent material.

The catalyst electrode 21b activates a redox couple, and may comprise a bi-phase platinum catalyst, particularly, a bi-phase platinum-titanium oxide catalyst.

The first substrate 10 is attached to the second substrate 20, using an adhesive 42. An electrolyte 30 is injected between the first electrode 11 and the second electrode 21, through a hole 25a penetrating the second substrate 20 and the second electrode 21. The electrolyte 30 is uniformly dispersed inside the porous film 13. The electrolyte 30 transfers electrons from the second electrode 21 to the dye 15, through oxidation and reduction. The hole 25a is sealed with an adhesive 42 and a cover glass 43.

One or more embodiments will now be described in further detail with reference to the following Examples. However, these examples are intended to be illustrative only.

### EXAMPLES

### Preparation of electrolyte for dye-sensitized solar cell

### Preparation Example 1

1.20 M 1-propyl-3-methylimidazolium iodide (available from Aldrich) and 0.12M iodine (available from Aldrich) were added to a solvent of N-methylpyrrolidone (NMP, available from Aldrich) and mixed together to prepare a mixed solution. 1,6-dibromohexane (available from Aldrich) as an additive was then added to the mixed solution in an amount of 2 parts by weight based on 100 parts by weight of the organic solvent to prepare an electrolyte.

### Preparation Example 2

An electrolyte was prepared in the same manner as in Preparation Example 1, except that polyoxyethylene-Q-tertoctylphenylether (available from Aldrich) was used as an additive instead of 1,6-dibromohexane (available from Aldrich).

### Preparation Example 3

An electrolyte was prepared in the same manner as in Preparation Example 1, except that sodium dodecyl sulfate (SDS, available from Aldrich) was used as an additive instead of 1,6-dibromohexane (available from Aldrich).

### Preparation Example 4

An electrolyte was prepared in the same manner as in Preparation Example 1, except that after being sintered at 500°C for 30 minutes, anatase-type TiO₂ particles (DT51D, manufactured by Millennium Chemicals, S.A.= 87m²/g, d= 15-25nm) in the form of a nanorod, having an average particle diameter of 20 nm, was added to the mixed solution in an amount of 15 parts by weight based on 100 parts by weight of the organic solvent, and the resulting mixture was then mixed using a centrifugal conditioning mixer (Thinky mixer) at 2,000 rpm for 30 minutes to prepare a gel-type electrolyte.

### Comparative Preparation Example 1

An electrolyte was prepared in the same manner as in Preparation Example 1, except that 1,6-dibromohexane (available from Aldrich) was not used.

### Comparative Preparation Example 2

An electrolyte was prepared in the same manner as in Preparation Example 1, except that tergitol-amine (available from Aldrich) was used as an additive instead of 1,6-dibromohexane (available from Aldrich).

### Comparative Preparation Example 3

An electrolyte was prepared in the same manner as in Preparation Example 1, except that decalinic acid (available from Aldrich) was used as an additive instead of 1,6-dibromohexane (available from Aldrich).

### Comparative Preparation Example 4

An electrolyte was prepared in the same manner as in Preparation Example 1, except that 1,6-dibromohexane (available from Aldrich) was not used, TiO₂ particles (DT51D, manufactured by Millennium Chemicals, S.A.= 87m²/g, d= 15-25nm) in the form of a nanorod, having an average particle diameter of 20 nm, was added to the mixed solution in an amount of 15 parts by weight based on 100 parts by weight of the organic solvent after being sintered at 500°C for 30 minutes, and the resulting mixture was then mixed using a centrifugal conditioning mixer (Thinky mixer) at 2,000 rpm for 30 minutes to prepare a gel-type electrolyte.

### Manufacture of dye-sensitized solar cell

### Example 1

A TiO₂ paste (PST-18NR, manufactured by JGC C&C, Japan) having a particle diameter of about 20 µm was coated to a thickness of 12 µm on a first conductive film (thickness: 2.3 mm) comprising a fluorine-containing tin oxide (FTO), formed on a surface of a first electrode, by screen printing, and the resultant was plasticized at 500°C for 30 minutes to prepare a porous film having a thickness of 12 µm. Subsequently, the resultant was maintained at 80°C and immersed in a 0.2 mN N719 dye solution dissolved in ethanol, and a dye adsorption treatment was then performed thereon for 24 hours. Thereafter, the dye-adsorbed porous film was washed with ethanol and dried at room temperature to complete the manufacturing of the first electrode with a light absorption layer formed thereon. A second electrode was formed by depositing a second conductive film formed of Pt on a first conductive film formed of a fluorine-containing tin oxide by sputtering for 20 minutes, and a hole was formed through the second electrode using a drill having a diameter of 0.1 mm for electrolyte injection. A support made of a hot melt film having a thickness of 60 µm (Suryln, manufactured by Dupont) was placed between the first electrode with the porous film formed thereon and the second electrode with the hole formed therethrough, and a hot press treatment was performed on the first and second electrodes using a hot press at 130°C for 15 seconds. Subsequently, the electrolyte prepared according to Preparation Example 1 was injected through the hole formed in the second electrode, thereby completing the manufacturing of a dye-sensitized solar cell.

### Example 2

A dye-sensitized solar cell was manufactured in the same manner as in Example 1, except that the electrolyte prepared according to Preparation Example 2 was used.

### Example 3

A dye-sensitized solar cell was manufactured in the same manner as in Example 1, except that the electrolyte prepared according to Preparation Example 3 was used.

### Example 4

A dye-sensitized solar cell was manufactured in the same manner as in Example 1, except that the electrolyte prepared according to Preparation Example 4 was used.

### Comparative Example 1

A dye-sensitized solar cell was manufactured in the same manner as in Example 1, except that the electrolyte prepared according to Comparative Preparation Example 1 was used.

### Comparative Example 2

A dye-sensitized solar cell was manufactured in the same manner as in Example 1, except that the electrolyte prepared according to Comparative Preparation Example 2 was used.

### Comparative Example 3

A dye-sensitized solar cell was manufactured in the same manner as in Example 1, except that the electrolyte prepared according to Comparative Preparation Example 3 was used.

### Comparative Example 4

A dye-sensitized solar cell was manufactured in the same manner as in Example 1, except that the electrolyte prepared according to Comparative Preparation Example 4 was used.

### Evaluation of efficiency of dye-sensitized solar cell

### Evaluation Example 1

The photocurrent-voltage characteristics of the dye-sensitized solar cells manufactured according to Examples 1 through 4 and Comparative Examples 1 through 4 were measured. The open circuit voltage, current density, and fill factor of each dye-sensitized solar cell were calculated from the measured photocurrent curve, and the efficiency of each dye-sensitized solar cell was calculated therefrom and represented as a percentage. An increase in the efficiency of each of the dye-sensitized solar cells of Examples 1 through 4 and Comparative Examples 2 through 4 based on the efficiency of the dye-sensitized solar cell of Comparative Example 1 was calculated and represented as a percentage. The results are shown in Table 1 below.

Herein, a xenon lamp was used as a light source, and the solar condition of the xenon lamp was corrected using a standard solar cell (Frunhofer Institute Solare Engeriessysysteme, Certificate No. C-ISE369, Type of material: Mono-Si+KG filter). 1 sun of light (the intensity of the light source was 100 mW/cm², and the standard condition of a solar spectrum for measuring the characteristics of solar cells satisfies the condition of AM 1.5G) was irradiated and the power density was adjusted to 100 mW/cm².

**Table 1**

| | Current density (J_{SC}) (mAcm²) | Open circuit voltage (V_{OC}) (V) | Fill factor (FF) (%) | Efficiency (%) | Efficiency increase (%) |
|---|---|---|---|---|---|
| Example 1 | 9.834 | 0.639 | 76.3 | 4.79 | 17.38 |
| Example 2 | 9.457 | 0.633 | 74.1 | 4.44 | 8.60 |
| Example 3 | 9.564 | 0.627 | 73.8 | 4.43 | 8.35 |
| Example 4 | 10.361 | 0.685 | 74.2 | 5.27 | 28.93 |
| Comparative Example 1 | 9.074 | 0.634 | 71.0 | 4.08 | |
| Comparative Example 2 | 7.687 | 0.655 | 71.2 | 3.58 | -12.13 |
| Comparative Example 3 | 9.279 | 0.587 | 68.9 | 3.75 | -8.02 |
| Comparative Example 4 | 9.161 | 0.683 | 73.4 | 4.59 | 12.44 |

Referring to Table 1, the current densities and fill factors (FF) of the dye-sensitized solar cells of Examples 1 through 4 are higher than those of the dye-sensitized solar cells of Comparative Examples 1 through 4.

In addition, the efficiencies and efficiency increases of the dye-sensitized solar cells of Examples 1 through 4 are higher than those of the dye-sensitized solar cell of Comparative Examples 1 through 3, and the efficiency and efficiency increase of the dye-sensitized solar cell of Example 4 are much higher than that of the dye-sensitized solar cell of Comparative Example 4.

This indicates that the dye-sensitized solar cell including the electrolyte including the additive including a linear carbon chain and an ionic or non-ionic neutral functional group at the end of the linear carbon chain exhibits increased efficiency, and the dye-sensitized solar cell including the electrolyte including the additive that further includes a nanoparticle filler exhibits much increased efficiency.

As described above, in an electrolyte for a dye-sensitized solar cell according to embodiments of the present invention, the viscosity of the high-density electrolyte is reduced, while the ionic conductivity of the electrolyte is increased, and the leakage of the electrolyte from the dye-sensitized solar cell is prevented. Therefore, a dye-sensitized solar cell including the electrolyte according to the present invention may exhibit enhanced durability and efficiency such as fill factor (FF).

While the present invention has been described in connection with certain exemplary embodiments thereof, it is to be understood that the invention is not limited to the disclosed embodiments, but, on the contrary, is intended to cover various modifications and equivalent arrangements included within the scope of the appended claims.

## Claims

1. An electrolyte for a dye-sensitized solar cell, the electrolyte comprising:
an organic solvent;
a redox derivative; and
an additive including a linear carbon chain, wherein the additive has an ionic or non-ionic neutral functional group located at one or more ends of the linear carbon chain.

2. The electrolyte of claim 1, wherein the linear carbon chain comprises from 3 to 20 carbon atoms.

3. The electrolyte of claim 1 or claim 2, wherein the linear carbon chain comprises at least one selected from the group consisting of a hetero atom, an arylene group, and a heteroarylene group.

4. The electrolyte of any preceding claim, wherein the additive comprises at least one ionic or non-ionic neutral functional group selected from the group consisting of -F, -Cl, -Br, -I, -NO₃, -CN, -OH, -SH, -CHO, -SbF₆⁻, -PF₆⁻, -AsF₆⁻,-(CF₃CO₂)⁻, -(C₂F₆CO₂)⁻, -(CF₃CF₂CF₂CO₂)⁻, -ClO₄⁻, -(p-CH₃C₆H₄SO₃)⁻, -(SO₃CF₃)⁻, - SO₄⁻, and -HPO₃⁻.

5. The electrolyte of any preceding claim, wherein the additive comprises at least one selected from the group consisting of 1,6-dibromohexane, sodium dodecyl sulfate (SDS), and polyoxyethylene-Q-tertoctylphenylether.

6. The electrolyte of any preceding claim, wherein an amount of the additive is in the range of 0.15 to 20 parts by weight based on 100 parts by weight of the organic solvent.

7. The electrolyte of any preceding claim, further comprising a nanoparticle filler.

8. The electrolyte of claim 7, wherein the nanoparticle filler comprises a nano-inorganic oxide.

9. The electrolyte of claim 7 or claim 8, wherein the nanoparticle filler comprises at least one selected from the group consisting of TiO₂, SiO₂, SnO₂, WO₃, ZnO, ITO, BaTiO₃, Nb₂O₄, In₂O₃, ZrO₂, Ta₂O₅, La₂O₃, SrTiO₃, Y₂O₃, Ho₂O₃, Bi₂O₃, CeO₂, and Al₂O₃.

10. The electrolyte of any of claims 7 to 9, wherein an average particle diameter of the nanoparticle filler is in the range of about 5 to about 400 nm.

11. The electrolyte of any of claims 7 to 10, wherein an amount of the nanoparticle filler is in the range of 0.2 to 40 parts by weight based on 100 parts by weight of the organic solvent.

12. The electrolyte of any preceding claim, wherein the organic solvent has a boiling point of 140°C or higher.

13. The electrolyte of any preceding claim, wherein the organic solvent comprises at least one selected from the group consisting of 3-methoxy propionitrile (MPN), N-methyl-2-pyrrolidone (NMP), ethylene carbonate (EC), propylene carbonate (PC), gamma-butyrolactone (GBL), valeronitrile, dimethylsulfoxide, dimethylformamide, diethylformamide, and dimethylacetamide.

14. The electrolyte of any preceding claim, wherein the redox derivative produces a I⁻/I₃⁻ redox couple.

15. A dye-sensitized solar cell comprising:
a first electrode on which a porous film with a dye adsorbed onto a surface thereof is formed;
a second electrode facing the surface of the first electrode on which the porous film is formed; and
an electrolyte according to any of claims 1 to 14 interposed between the first electrode and the second electrode.
